# EUROPEAN PATENT SPECIFICATION

(11) **EP 0 854 671 B1**
(45) Date of publication and mention of the grant of the patent: **15.06.2005**
(21) Application number: 98100552.3
(22) Date of filing: 14.01.1998
(51) Int. Cl.: H05K 13/04, H05K 13/08

(54) **A method for recognizing at least one component, component recogniton device and machine comprising the same**
Ein Verfahren zur Erkennung mindestens eines Bauteils, Vorrichtung zum Erkennen von Bauteilen und eine diese enthaltende Vorrichtung
Procédé pour reconnaître au moins un composant, dispositif de reconnaissance de composants et machine le comportant

(30) Priority: 20.01.1997 JP 811697
(43) Date of publication of application: 22.07.1998
(73) Proprietor: YAMAHA HATSUDOKI KABUSHIKI KAISHA, Iwata-shi Shizuoka-ken, 438 (JP)
(72) Inventor: Aoshima, Yasuaki, Iwata-shi, Shizuoka-ken (JP)
(74) Representative: Grünecker, Kinkeldey, Stockmair & Schwanhäusser Anwaltssozietät

(56) References cited:
- PATENT ABSTRACTS OF JAPAN vol. 17, no. 242 (P-1535), 14 May 1993 & JP 04 364404 A (MATSUSHITA ELECTRIC IND CO LTD), 16 December 1992,
- PATENT ABSTRACTS OF JAPAN vol. 18, no. 340 (E-1569), 27 June 1994 & JP 06 085500 A (YAMAHA MOTOR CO LTD), 25 March 1994,
- PATENT ABSTRACTS OF JAPAN vol. 12, no. 380 (P-769), 12 October 1988 & JP 63 124938 A (OMRON TATEISI ELECTRONICS CO), 28 May 1988,
- PATENT ABSTRACTS OF JAPAN vol. 96, no. 2, 29 February 1996 & JP 07 288398 A (MATSUSHITA ELECTRIC IND CO LTD), 31 October 1995,

## Description

The present invention relates to a method for recognizing at least one component. The present invention furthermore relates to a component for recognition device. Furthermore, the present invention relates to a mounting machine comprising a component recognition device, e.g., for picking up electronic components and fixing the same on a printed circuit board.

A mounting machine has been generally known in which a head unit equipped with a nozzle member or nozzle members for component attraction picks up ICs and other components from a component feeder, transfers them to a printed circuit board positioned in a fixed position, and mounts them in a fixed position on the printed circuit board.

In this type of mounting machine, there is some degree of disparity in position when components are picked up by the nozzle or nozzles, making it necessary to correct the mounting positions of the components because of offset in the positions of the components when picked up. For this reason, the mounting machine of prior art is designed to recognize the component which has been picked up, detect offset in the position at which the component has been picked up in relation to the nozzle member, and, if the component is irregular, for example, is a component having leads, detect any irregularities such as bent leads.

The device of prior art proposes, in this type of component recognition device, for instance, positioning an imaging device consisting of a line sensor and other components, and an illumination device, on the base of a mounting machine, and moving the head unit over the imaging device after the component has been picked up; and then, as the attracted component is being radiated by the illumination device with the amount of light required for recognition of the component, imaging is carried out, and component recognition is carried out based on the image read as a result.

JP-A-06 085 500 discloses a part recognition device adapted to control brightness of an image of the part to be recognized and to keep same brightness on an adequate level, in case ambient light rays are varying in brightness depending on installation spot or in case a lighting equipment changes in brightness with time. Therein the part to be recognized is irradiated with a lighting device, a camera takes the image and the position of the part to be recognized relative to its holding means is detected. The brightness of the image is compared with a previously determined reference value changing the lighting power supply in light volume.

### Problem to be Solved by the Invention

Generally, in the component recognition device of prior art, an LED lamp is used as the illumination device, and in order to suppress fluctuation in the brightness of the lamp, a fixed-current circuit is used to supply constant current to the LED lamp. With this configuration, however, if the heat generated by the LED lamp after it lights causes changes in the temperature, the brightness also fluctuates sharply, due to the changes in the temperature. These changes affect the clearness and detail of the component image, and lower the image recognition ratio.

In order to avoid fluctuation in brightness caused by temperature changes, the LED lamp can be left lighted at all times, even when image recognition is not being carried out, so as to stabilize the temperature. In this case, however, it becomes necessary to consider other means of discharging the heat produced by the LED lamp in order to avoid overheating, leading to excessive power consumption. In addition, it is difficult to completely suppress changes in the temperature caused by fluctuation in the external temperature and other factors, making it difficult to achieve fine adjustments of the brightness.

In addition, the optimum brightness for image recognition varies depending on the type of attracted component, and ideally, it would be possible to adjust the brightness of the light from the illumination source based on the type of attracted component, but this has been difficult using conventional methods.

Assuming that images are captured while the head unit or component is moving, the travel speed affects the image intensity, because the intensity remains at the same level as the travel speed increases, resulting in darker images.

This invention was developed for the purpose of solving this problem, and is aimed at enabling appropriate adjustment of the brightness of the light emitted from the illumination device to irradiate the product. This would enable a mounting machine with a component recognition device capable of improved component recognition precision.

### Means for Solving the Problem

The problem underlying the present invention with respect to the method is solved by a method for recognizing at least one component as defined in claim 9. Preferred embodiments of the inventive method are defined in the dependent claims 10 to 12. The underlying problem with respect to the component recognition device is defined in claim 1. Preferred embodiments of the inventive component recognition device are defined in claims 2 to 7. The present invention further provides a mounting machine comprising such component recognition device as defined in claim 8.

Preferably, the component recognition device is equipped with a head unit having a nozzle member for attracting components, an imaging unit for imaging components picked up by the nozzle element, and an illumination device to irradiate the component with light when the component is being imaged. The device is preferably configured so as to carry out recognition of components picked up by a nozzle member based on an image of the component read by said imaging device, the intensity of the light with which said component is illuminated by said illuminating device is detected by an illumination light detecting device, with the intensity of said light being set as a target value, and said target value is then compared with the value detected by said illumination light detecting device, with a control device controlling the volume of light emitted by said illumination device in response to the deviation of the two values.

Using this configuration, feedback control is implemented by said control device based on the detection data from the illumination light detecting device, with adjustment being carried out by said feedback control device so that the intensity of the light irradiating said component is consistent with the target value, and the appropriate intensity is maintained for the captured component image.

In the invention described herein, given that said illumination device is equipped with a light-emitting device consisting of an LED, and said control device is designed in such a way that it controls the conductive current in relacion to said LED, the intensity can be maintained at the appropriate intensity by controlling said conductive current in response to changes in intensity which may occur because of fluctuation in the temperature of the LED.

Ideally, this invention shall be configured such that the elements of said imaging device and said illumination light detecting device are of approximately equivalent sensitivity. Based on this configuration, the intensity would be detected by said illumination light detecting device at the same sensitivity as that of the imaging device and the intensity of the component image would be adjusted appropriately.

Furthermore, the invention described herein may be configured such that said imaging device consists of a line sensor positioned within the movement path of said head unit, with imaging carried out as the head unit travels relative to the line sensor; at the same time, a travel speed detection device detects the speed at which the head unit is moving in relation to said line sensor, so that said target value can be adjusted by said setting device in response to said travel speed.

Said control device should be designed so as to include control such that the illumination device lights as the head unit approaches a fixed position in relation to said line sensor, and as the head unit passes the line sensor, the illumination unit is turned off, in order to conserve power. In addition, the intensity should be adjusted to the appropriate level using feedback control.

Said setting device should be designed in such a way that it sets said target value in response to the type of component picked up by said nozzle member, in order to provide the appropriate intensity for each individual component.

Furthermore, said illumination light detecting device should be provided outside of the path along which the light directed from the illumination device at said component travels, in order to enable detection of an intensity which is nearly proportional to the intensity of the light with which the component is irradiated.

Alternatively, said illumination light detecting device may be provided in the vicinity of the nozzle in the head unit, thus enabling direct detection of the intensity of the light with which the component is irradiated.

### [Brief Description of the Drawings]

[Fig. 1]
   This is a plane figure of the mounting machine showing an example of the component recognition device described in this invention.
[Fig. 2]
   This is a front view of the same machine.
[Fig. 3]
   This is an enlarged cross-section view indicating the imaging unit.
[Fig. 4]
   This is a circuit configuration drawing of the component recognition device.
[Fig.5]
   This is a block drawing indicating the configuration of the illumination control block.
[Fig. 6]
   This is a flowchart showing the illumination control operation.
[Fig. 7]
   This is a graph showing the relationship between the travel speed of the head unit and the volume of light from the illumination device.
[Fig. 8]
   This is a block diagram showing a different example of the configuration of the illumination control block.
[Fig. 9]
   This is an enlarged cross-section view showing a different example of the layout of the photosensors in the imaging unit.
[Fig. 10]
   This is an enlarged cross-section view showing yet another example of the layout of the photosensors.
[Fig. 11]
   This is a plane figure showing a different example of a mounting machine in which this invention is applied.
[Fig. 12]
   This is a front view of the same machine.
(Fig. 13]
   This is a side view of the same machine.

### [Embodiment of the Invention]

An embodiment of this invention will be described with reference to the accompanying drawings.

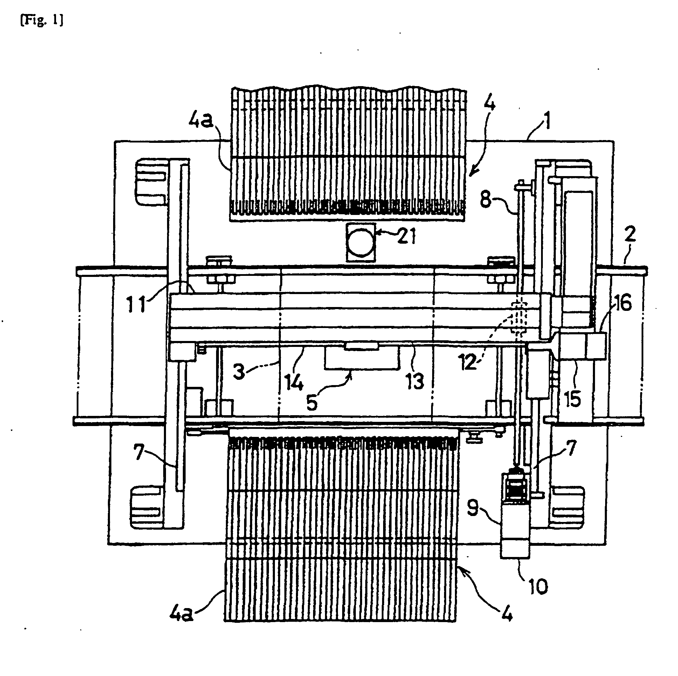

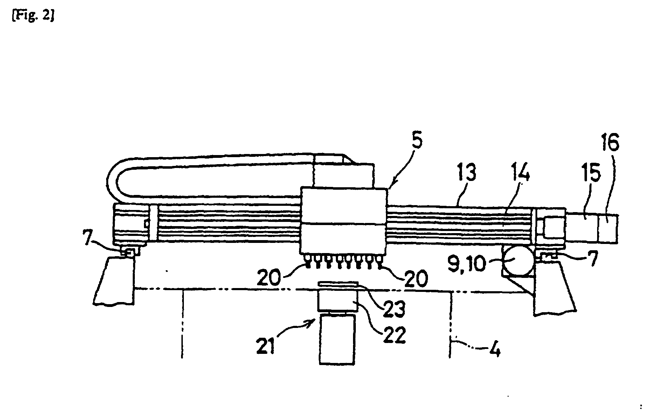

Fig. 1 and Fig. 2 show the configuration of a mounting machine incorporating the component recognition device described in this invention. As shown in the figures, on a bed 1 of the mounting machine is arranged a conveyor 2 for conveying substrates, on which a substrate 3 is conveyed and halted at a given position for mounting work. On both sides of the conveyor 2 are positioned component feeders 4, each provided with feeders, for example, multiple rows of tape feeders 4a.

Upwards of the base 1 is a head unit 5 for mounting components. This head unit 5 is movable over the region from the component feeders 4 to the component mounting section where the substrate 3 is located, and in this embodiment, it is movable in the X direction (the direction parallel to the conveyor 2) as well as in the Y direction (the direction perpendicular to the X axis in the horizontal plane).

That is, on the bed 1 are arranged fixed rails 7 extending in the Y direction and a ball screw shaft 8 driven for rotation by a Y axis servo motor 9, and on the fixed rails 7 is positioned a head unit support member 11; a nut 12 provided in the support member 11 is fitted on the ball screw shaft 8. On the support member 11 are arranged a guide member 13 extending in the X direction and a ball screw shaft 14 driven by an X axis servo motor 15; the guide member 13 supports the head unit 5 to enable movement, and a nut (not shown) provided in the head unit 5 is fitted on the ball screw shaft 14. The support member 11 is moved in the Y direction when the Y axis servo motor 9 operates, and the head unit 5 is moved in the X direction relative to the support member 11 when the X axis servo motor 15 operates.

The Y axis servo motor 9 and X axis servo motor 15 are provided with rotary encoders 10 and 16, respective, for detecting the movement position of the head unit 5.

The head unit 5 is equipped with a nozzle member 20 for picking up tip components. As shown in Fig. 2, there are eight nozzle members 20 aligned in the X axis direction in this implementation configuration. These nozzle members 20 are capable of moving in the perpendicular direction in relation to the frame of the head unit 5, as well as rotating around the nozzle center axis, and are driven by a perpendicular drive mechanism and rotation drive mechanism located beyond the borders of the figure. This perpendicular drive mechanism is equipped with an overall perpendicular drive servo motor capable of driving, for example, all of the nozzle members 20 simultaneously, as well as a constant number (eight) of air cylinders capable of driving each individual nozzle member 20 for a fixed stroke length in the perpendicular direction, and is configured such that the perpendicular drive servo motor and the eight air cylinders can be used in combination to raise and lower the individual nozzle members 20 between a fixed ascent position and a fixed descent position. The rotation drive mechanism consists of a single servo motor for rotation and transfer mechanisms which convey the rotation of the servo motor to each of the individual nozzle members 20.

On the sides of the component feeders 4 are arranged imaging units 21 which are designed to recognize components picked up by the various nozzle members 20 of the head unit 5.

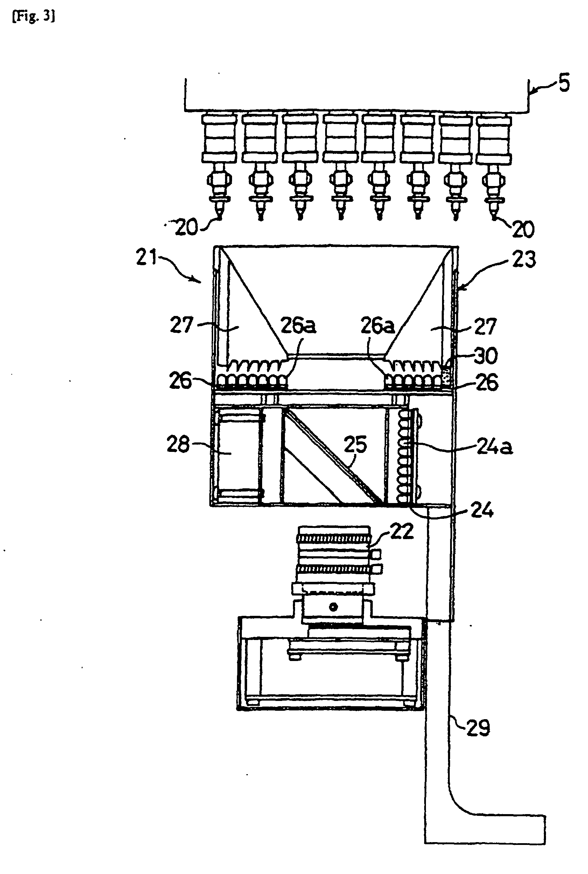

The imaging unit 21 is, as shown in Fig. 3, equipped with a camera 22 (imaging device) designed to capture images of components (attracted components) picked up by the nozzle member 20, as well as an illumination unit 23 (illumination device) positioned above the camera 22, which irradiates the component with light as it is picked up. The camera 22 consists of a device such as, for example, a line sensor. This line sensor is equipped with CCD solid-state imaging elements lined up in the direction (Y direction) which intersects the direction in which the nozzle members 20 are positioned, and form one-dimensional component images through a slit section.

When mounting is carried out, after the components have been picked up by the nozzle members 20 of the head unit 5, the head unit 5 moves in the direction (sub-scanning direction: X direction) which intersects the direction of the array in which the line sensor elements are aligned (main scanning direction: Y direction), and the image in the main scanning direction of the component which has been picked up by the nozzle members 20 provides specific video signals read sequentially in the sub-scanning direction and output by the camera 22.

The illumination section 23 is equipped with a light-emitting component such as an LED, and in the embodiment shown in Fig. 3, is positioned at one side of the space provided for image input to the camera 22; in addition to directing the light from numerous LEDs 24a located on the vertically positioned LED board 24 towards the attracted component, it also possesses a half-mirror 25 which is interposed within the image input space in order to conduct the light from the attracted component towards the camera 22, and prisms 27 which direct the light from numerous LEDs 26a located on the horizontally positioned LED boards 26, located on both sides of the image input space, above the half-mirror 25, towards the attracted component. A cooling fan 28 is incorporated in the illumination device 23, and the illumination device 23 and the camera 22 are both attached to the fixed frame 29 of the mounting machine base.

The imaging unit 21 also contains a photosensor 30 (illumination light detecting device) which detects the intensity of the light with which the attracted component is irradiated. This sensor 30 consists of a photodiode with approximately the same characteristics as the camera 22, and is positioned in the vicinity of the illumination device 23 where the LEDs are located and is also outside of the path of the light directed towards the attracted component, and at the side of the LED board 26 in this implementation configuration.

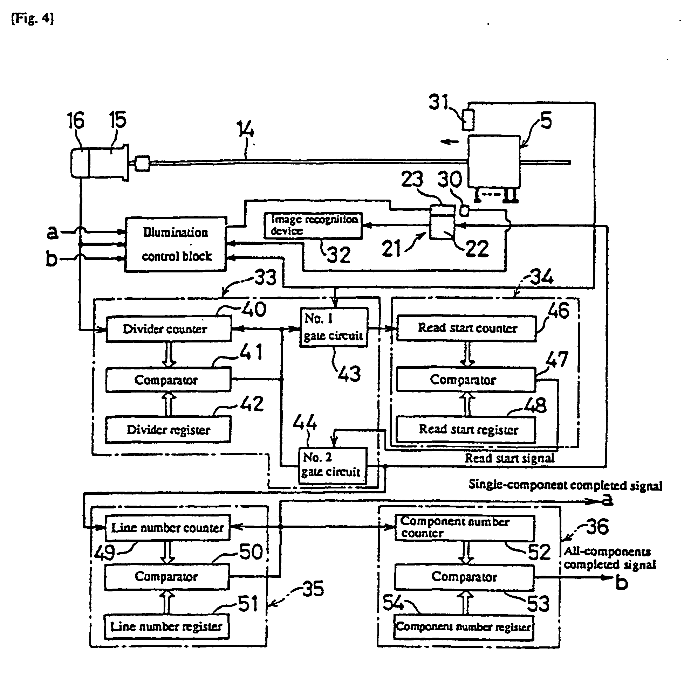

On the base 1 of the mounting machine, near the imaging unit 21, there is a head detection sensor 31 (shown in Fig. 4) which detects the approach of the head unit 5 to the imaging unit 21, and when a component is recognized, the time at which reading of the component image by the line sensor 24 begins is calculated by the head unit 5 being detected by the head detection sensor 31.

The overall configuration of the mounting machine described in the foregoing embodiment is omitted here, but the mounting machine is equipped with a control unit configured of a microcomputer, with the X axis and Y axis servo motors 9 and 15, the perpendicular drive mechanism and rotational drive mechanism for the pickup nozzle members 20 of the head unit 5, the camera 22 of the imaging unit 21, the illumination unit 23 and other devices electrically connected to this control unit and being controlled as a single unit.

This control unit, as shown in Fig. 4, includes an image recognition unit 32, a clock signal generating device 33, a start signal generating device 34, a single-component completed signal generating device 35, an all-components completed signal generating device 36, and an illumination control block 37 (control device).

The clock signal generating device 33 is configured of a divider counter 40, a comparator 41, a divider register 42, and Nos. 1 and 2 gate circuits 43 and 44. Clock signals are generated and output by dividing pulse string signals output from the position detection device 16.

Specifically, the number of pulses of the pulse string signal output from the position detection device 16 is counted by the divider counter 40 and is compared by the comparator 41 to a count number N specified in advance in the divider register 42. When the number of pulses reaches the count number N, the signal for one pulse is output from the comparator 41.

In other words, a relative correspondence is established between the head unit 5 and the camera 22 consisting of the line sensor, and the X axis servo motor 15 drives the head unit 5 to move it in relation to the camera 22, so that as the head unit 5 is moving in the X axis direction, the pulse string signal output from the position detection device 16 is divided by the count N to generate a clock signal.

The generated clock signal output from the comparator 41 to the No. 1 and No. 2 gate circuits 43 and 44. The detection signal output from the head detection sensor 31 is input to the No. 1 gate circuit 43, which causes the clock signal to be output from the No. 1 gate circuit 43 to the start signal generating device 34. The reading start signal output from the start signal generating device 34 (to be described later), is input to the No. 2 gate circuit 44, which causes the clock signal from the No. 2 gate circuit 44 to be output to the imaging unit 21 and the single-component completed signal generating device 35.

The start signal generating device 34 is configured of a read start counter 46, a comparator 47 and a read start register 48; the clock signal output from the No. 1 gate circuit 43 is counted at the read start counter 46, and in the comparator 47, is compared to a number of counts specified in advance in the read start register 48. The number of counts specified in advance is specified in such a way that it corresponds to the distance traveled by the head unit 5 between being detected by the head detection sensor 31 and arriving in front of the imaging unit 21. When the specified number of counts is reached, a read start signal is output from the comparator 47 to the No. 2 gate circuit 44. When the read start signal is output to the No. 2 gate circuit 44, output of the clock signal to the imaging unit 21 begins, as described previously, and this initiates reading of the component image by the camera 22, at a timing synchronized to the clock signals.

The single-component completed signal generating device 35 is configured of a line number counter 49, a comparator 50 and a line number register 51. The clock signals output from the No. 2 gate circuit 44 are counted by the line number counter 49, and are compared by the line number register 51 to a number of counts specified in advance. When the number of clock signals reaches the specified number of counts, a single-component completed signal is output from the comparator 50 to an all-components completed signal generating device 36 and an illumination control block 37, which indicates that reading of the component image for a single component by the camera 22 has been concluded.

The number of counts specified in the line number register 51 is based on the type of the target component being recognized and on other factors, and is set as a value which enables a single component image to be read.

The all-components completed signal generating device 36 is configured of a component number counter 52, a comparator 53 and a component number register 54. When the single-component completed signal generating device 34 outputs single-component completed signals, the signals are counted by the component number counter 52, and in the comparator, are compared to a number of counts specified in advance in the component number register 54. When the number of signals reaches the specified number, all-components completed signals are output from the comparator 53 to the image recognition unit 32 and the illumination control block 37; in other words, a signal is output indicating that component image reading of all components by the camera 22 should be stopped.

The image recognition unit 32 writes the image data read by the camera 22 in synchronization with the clock signals to the image memory, and the component is recognized by means of the specified image processing being carried out on the image data.

The illumination control block 37 inputs pulse string signals output from the position detecting device 16, detection signals from the head detecting sensor 31, detection signals from the photosensor 30 provided in the imaging unit 21, single-component completed signals, all-components completed signals, and other signals. Based on these signals, signals which control the volume of light are then output in relation to the illumination unit 23 of the imaging unit 21.

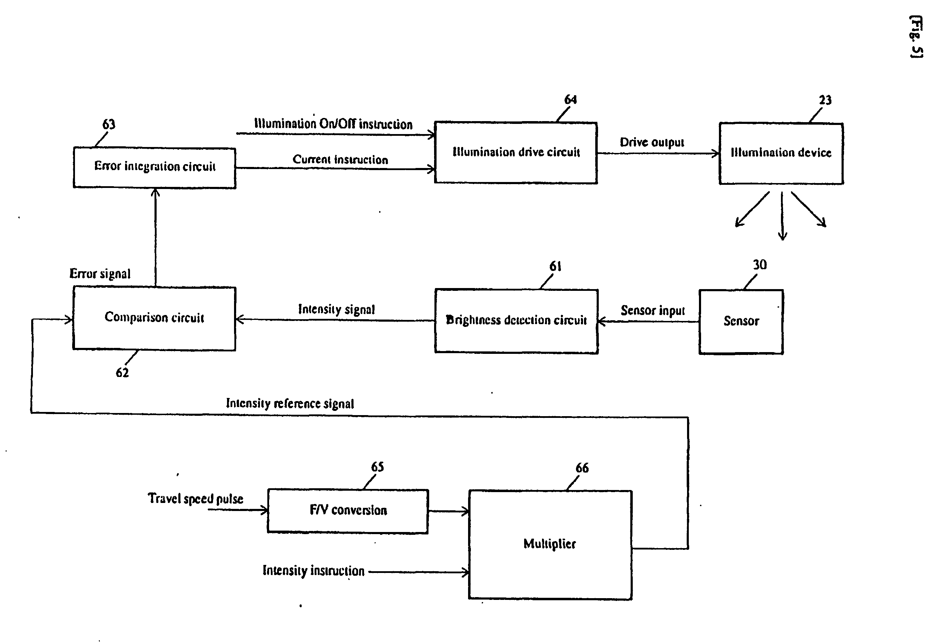

Describing the specific configuration of the illumination control block 37 as shown in Fig. 5, the illumination control block 37 has a feedback control system comprising an intensity detecting circuit 61, a comparison circuit 62, an error integration circuit 63 and an illumination drive circuit 64. This feedback control system is designed to control the volume of light of the illumination unit 23 so that the intensity of the light detected by the photosensor 30 is adjusted to the target value. In other words, the degree of brightness of the light with which the attracted component is irradiated by the illumination unit 22, based on the detecting signals from the photosensor 30, is detected by the intensity detecting circuit 61, and the intensity signal is input to the comparison circuit 62 along with an intensity reference signal which correlates to the target value.

An error signal indicating the error (deviation) between the intensity reference signal and the intensity signal is output from the comparison circuit 62, and the error integration circuit 63 supplies a current instruction signal to the illumination drive circuit 64 in response to the value resulting from integration of the error signals. Illumination on and off instructions from an external CPU, including illumination control block 37, are also supplied to the illumination drive circuit 64.

When there is an Illumination On instruction, the illumination drive circuit 64 outputs the drive output (current control signal) resulting from the current instruction signal to the illumination device 23 of the imaging unit 21, and when there is an Illumination Off instruction, the drive output for the illumination to be turned off is terminated.

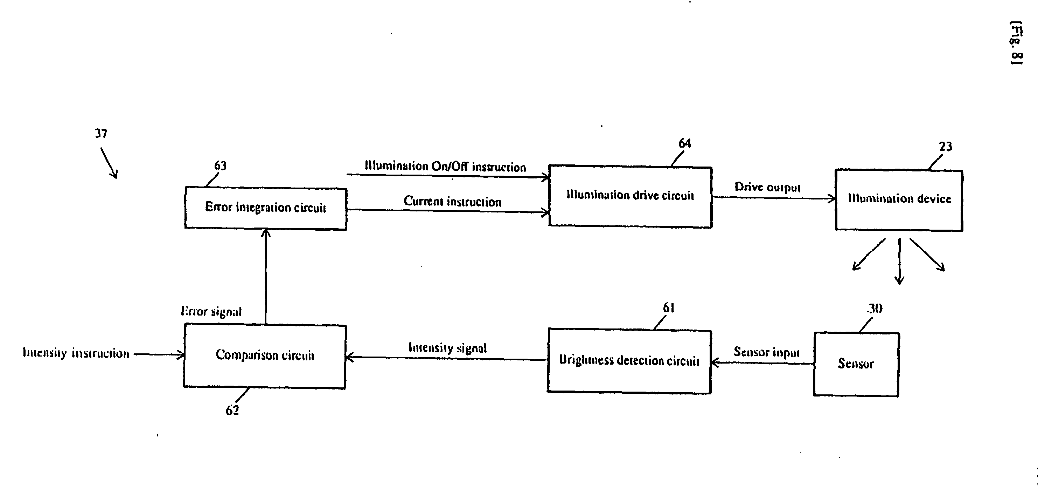

The intensity reference signal, in this implementation configuration, is set based on the intensity instruction corresponding to the component, and on the travel speed of the head unit 5. In other words, because the optimum image brightness varies for each individual component, intensity instructions based on the attracted components are determined by a CPU (not shown), based on component data stored in the memory in advance. Furthermore, because the travel speed of the head unit 5 affects the image brightness, travel speed pulses (pulse string signals from the position detecting device 16) are converted to voltage in the F/V converter 65 (travel speed detecting device) to detect the travel speed. This travel speed and the intensity instruction are then multiplied in the multiplier unit 66 and an intensity reference signal is supplied. Consequently, as shown in Fig. 7, the intensity reference signal changes in accordance with the degree of illumination of the illumination device 23, proportional to the travel speed of the head unit 5.

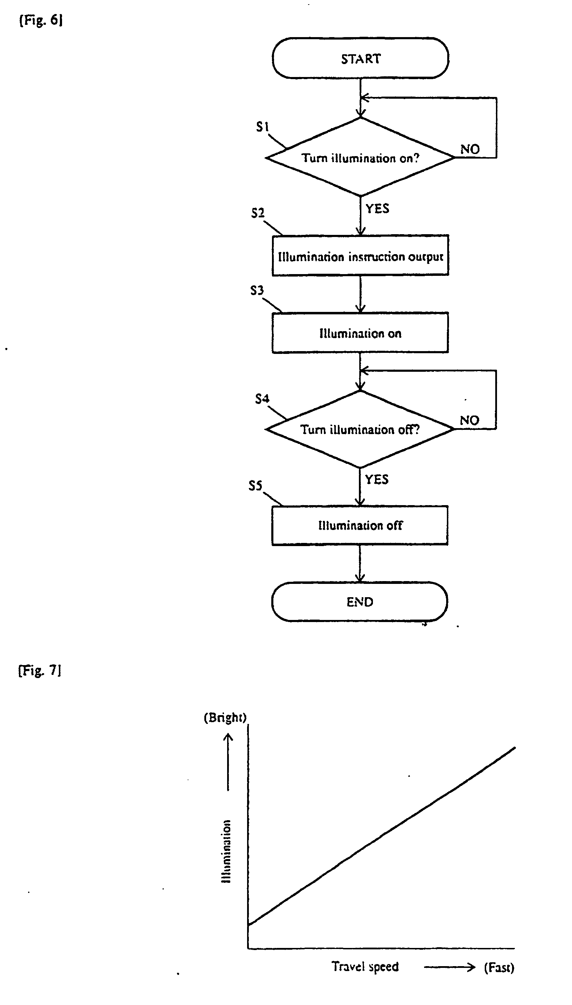

Fig. 6 shows the flow of operation based on an external CPU or other instruction sources included in the illumination control block 37. When this operation flow is initiated, a decision is first made as to whether or not illumination is to be turned on, based on the signals from the head detecting sensor 31 (step S1). Next, when the head detecting sensor 31 detects the approach of the head unit 5 to a fixed position in relation to the imaging unit 21, a decision is made to turn on the illumination, and at the same time that an intensity instruction is output in response to the attracted component, an Illumination On signal is output, which initiates feedback control of the brightness of the illumination device 23 based on the feedback control system shown in Fig. 5 (steps S2 and S3).

Next, a decision is made as to whether the illumination is to be turned off or on, based on signals such as the all-components completed signal (step S4), and then a decision is made as to whether the illumination is to be turned off once recognition of all of the components picked up by the various nozzle members 20 of the head unit 5 has been completed, and the Illumination Off signal is output (step S5).

The movements of the component recognition device configured as described above will now be explained in conjunction with the mounting operation of the mounting machine.

In the mounting machine, when mounting operation begins, the head unit 5 is moved to the component feeder unit 4, and components are picked up by the various nozzle members 20. When the component pickup has been completed, the head unit 5 moves over the imaging unit 21. Next, if the camera 22 of the imaging unit 21 consists of a line sensor, as shown in this implementation configuration, the head unit 5 moves in relation to the camera 22, in order for component recognition to be carried out. Specifically, the head unit is moved along the X axis direction from one end to the other, following a travel path in relation to the imaging unit 21.

When movement begins in order to initiate component recognition, and the head unit 5 is detected by the head detecting sensor 31, an Illumination On signal is supplied to the illumination drive circuit 64, which in turn supplies conductivity to the illumination device 22 and turns on the illumination. Counting of clock signals output from the clock signal generating device 33 begins, and when the number of signals reaches the specified number, a component image reading start signal is output from the start signal generating device 34, and reading of the component image is begun by the camera 22.

Next, at a timing synchronized to the clock signals, the image in the main scanning direction of the attracted component is read, followed by that in the sub-scanning direction, and the image data is stored in the memory of the image recognition device 32. At the same time, when image reading for one component has been completed, a single-component completed signal is output from the single-component completed signal generating device 35, and image reading of the next component begins in the same way. This process is repeated until component images have been read sequentially for all of the components.

In this way, the head unit 5 continues to move and images of the attracted components are read by the camera 22. During this time, in the illumination control block 37, feedback control based on a comparison of intensity signals taken from the signals coming from the photosensor 30 and intensity reference signals is used to control supply current in relation to the illumination device 23 in order to maintain intensity signals that are consistent with the intensity reference signals. As a result, the volume of light output from the illumination device 23 is controlled to eliminate fluctuation caused by changes in the temperatures of LED24a and LED26a in the illumination device 23, and the brightness of images read by the camera 22 is adjusted to the appropriate level. This results in heightened precision in component recognition.

In particular, if the photosensor 30 is configured of photodiodes having approximately the same characteristics as the camera 22, brightness can be effectively controlled in terms of temperature changes and other factors. That is, with an ordinary LED lamp, if the temperature fluctuates, the brightness changes, and there is a tendency for the emitted wavelength to change as well. Because the sensitivity of the camera 22 varies depending on the wavelength, there is a possibility of the brightness of the screen of the camera 22 changing in response to changes in the emitted wavelength, even though the light volume of the LED lamp is the same. However, if control is initiated using a photosensor 30 with the same type of elements as the camera 22, changes in sensitivity accompanying changes in wavelength are similar to those of the camera 22, and the brightness of images read by the camera 22 can be controlled to the appropriate brightness.

Using illumination control as described above, if intensity instructions are supplied in response to the type of attracted component, the optimum image brightness for the component can be obtained, and component image recognition remains stable and precise over continuous acquisition of images of various types of components.

Furthermore, with this implementation configuration, as shown in Figs. 5 and 7, because illumination reference signals are specified in such a way as to change the degree of illumination of the illumination device 23 in response to the travel speed of the head unit 5, the illumination of images captured by the camera 22 can be adjusted to the appropriate brightness, even if the travel speed of the head unit 5 changes. Consequently, there is no need to maintain the movement of the head unit 5 at a constant speed, and images can be captured and recognized at the appropriate brightness even while the head unit 5 is accelerating or decelerating.

As a result, the conventional necessity for approach operation to maintain the head unit at a constant speed has been eliminated, and the space required for approach movement can be reduced, enabling a higher degree of freedom in the installation location of the line sensor, and effectively reducing the amount of space needed for the mounting machine. In addition, mounting time can be reduced by the amount of time previously required for approach operation, thus boosting mounting efficiency.

Furthermore, as described above, control is initiated to maintain the appropriate brightness despite fluctuations in the temperatures of LED24a and LED26a in the illumination device 23, eliminating the conventional necessity to keep the LEDs in the illumination device at a constant temperature. In this implementation configuration, the illumination device 23 lights immediately before the head unit 5 approaches the imaging unit 21 and component recognition begins, and the illumination device 23 goes off when recognition of all of the components has been completed, which enables power consumption to be reduced significantly in comparison with conventional methods in which illumination remained on at all times.

The specific configuration of the devices in this mounting machine may be changed in various ways.

For instance, in the implementation configuration described above, the camera 22 is configured of a line sensor, but an area sensor configuration may also be used. Also, in the component recognition operation, the attracted component on each nozzle member 20 is stopped above the camera consisting of an area sensor for imaging, so that the head unit 5 can be moved at intermittent intervals. In this case, the control initiated by the illumination control block 37 regarding the travel speed of the head unit 5 is no longer necessary, so the configuration of the control system can be changed from that shown in Fig. 5 to that shown in Fig. 8, in which the F/V converter 65 and the multiplier unit 66 have been eliminated, and intensity instructions can be input directly to the comparison circuit 62.

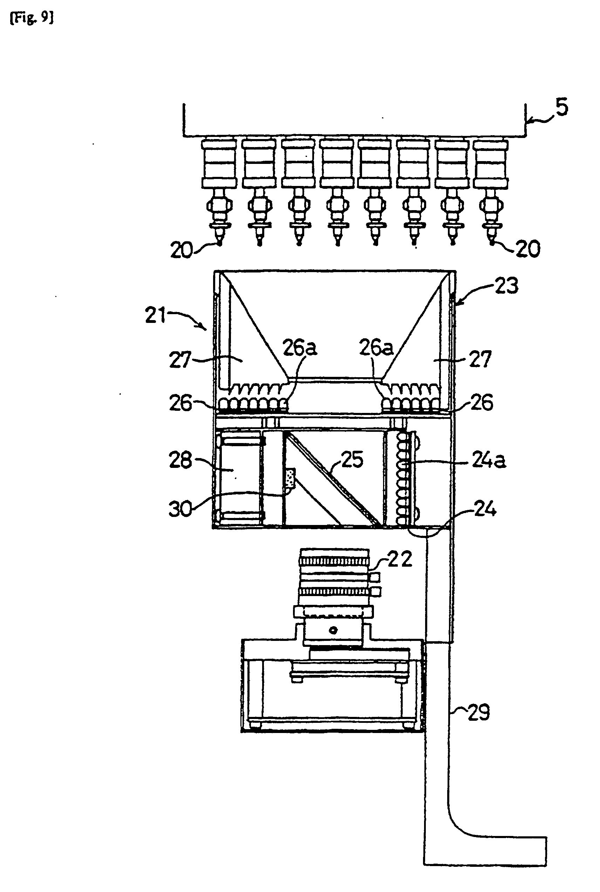

Furthermore, as an illumination light detecting device, in the implementation configuration described above, the photosensor 30 is positioned at the end of the side of the LED board 26. However, as shown in Fig. 9, part of the light reflected from LED24a on the LED board 24 by the half-mirror 25 is reflected upwards (in the direction in which the attracted component must be irradiated), and the remaining light passes through and is used, with the half-mirror being narrowed and the photosensor 30 being positioned diagonal to the LED board 24.

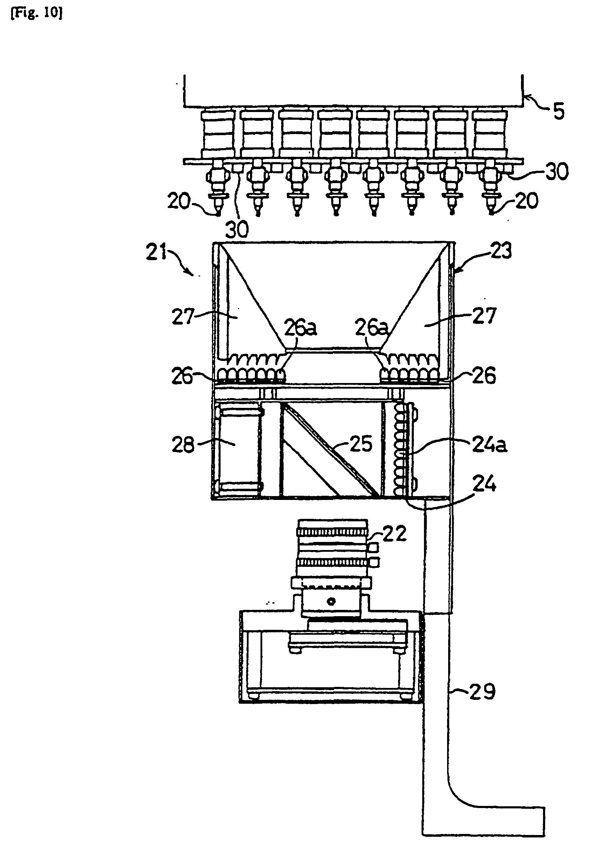

Another possibility is shown in Fig. 10, where photosensors 30 can be positioned in the vicinity of the nozzle members 20 of the head unit 5. In this configuration, the light with which the attracted components on the nozzle members 20 are irradiated is detected directly, which offers a higher degree of detection precision. However, the same number of photosensors must be provided as nozzle members 20, so that using an imaging unit 21 as shown in Fig. 3 or Fig. 9 proves advantageous in that fewer parts are required.

Another possibility is a configuration in which an area of constant intensity exists in a background area when imaging of attracted components is carried out by the camera 22, and the brightness of that section of the screen is detected in order to use the camera 22 to configure an illumination light detecting device.

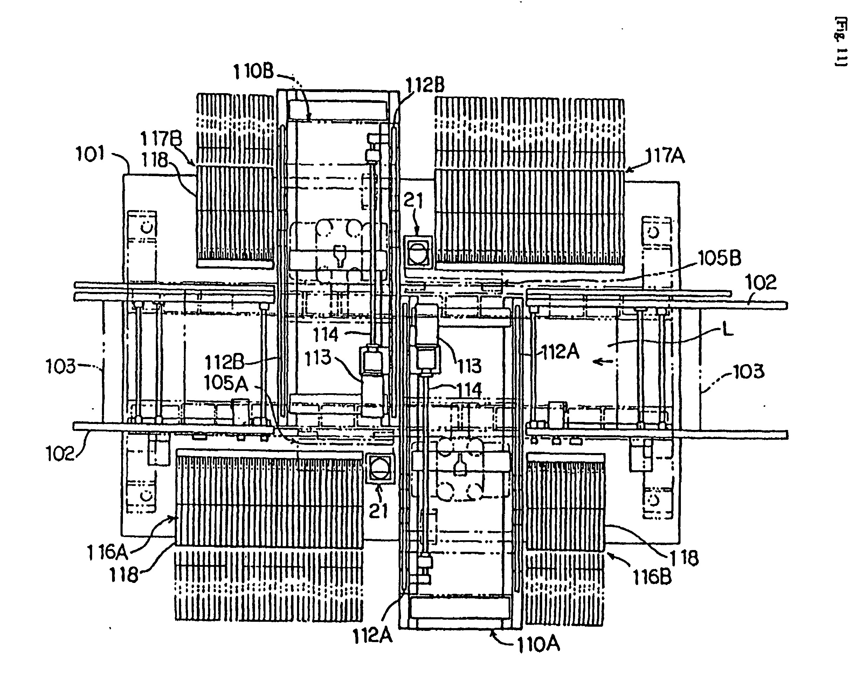

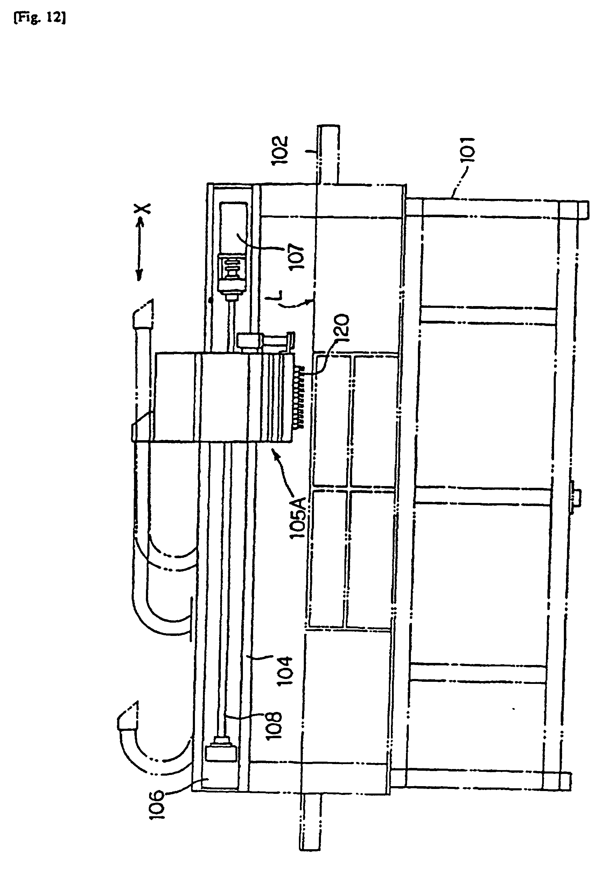

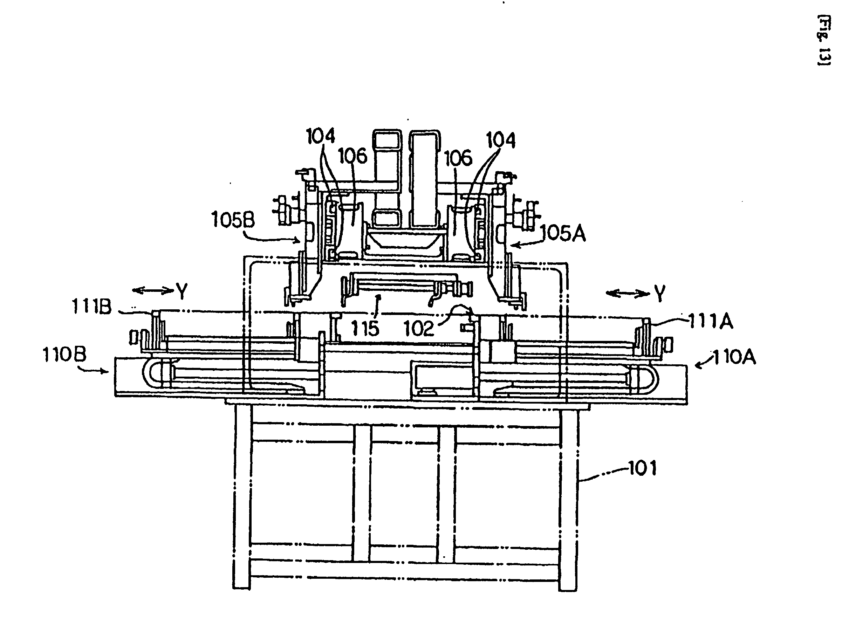

The component recognition device using this invention may also be configured, for example, as shown in Figs. 11 to 13. In the mounting machines shown in these figures, the head moves along a linear path in the X direction, while a work station which maintains the substrate may move in the Y axis direction. In the examples shown in these figures, there are two head units 105A and 105B provided, along with work stations 110A and 110B provided at two locations.

To describe the above in specific terms, there is a transport line L consisting of a conveyor 102 which transports a substrates 103 on a base 101, and at the same time, upwards of this transport line L, a supporting member 106 is installed extending in the X axis direction. On this supporting member 106 are located a fixed rail 104 which extends in the X axis direction and a ball screw shaft 108 for which rotation drive is supplied by an X axis servo motor 107, with a head unit 105A installed on the fixed rail 104 such that it moves freely. A nut (not shown) on the head unit 105A is fitted on the ball screw shaft 108. The operation of the X axis servo motor 107 causes the ball screw shaft 108 to rotate, allowing the head unit 105A to move in the X axis direction. The above explanation pertains to the drive system of the head unit 105A, but the drive system of the other head unit 105B is also configured in the same way.

Work stations 110A and 110B are installed in point symmetry positions in relation to the transport line L, on the outside of the supporting member 106, and substrate holding devices 111A and 111B are provided which hold the substrate 103 in the respective work stations 110A and 110B.

A fixed rail 112 extending in the Y axis direction on the base 101 and a ball screw shaft 114 which drives the rotation of the Y axis servo motor 113 are installed at locations in point symmetry to the work stations, with the work stations 110A and 110B movable along the fixed rail 112 and, at the same time, nuts (not shown) provided on the work stations 110A and 110B are fitted on the ball screw shaft 114. The operation of the Y axis servo motor 113 turns the ball screw shaft 114, which in turn moves the work stations 110A and 110B in their respective Y axis directions.

Furthermore, a transfer unit 115 is located along the transfer line L, between the transfer line L and the work stations 110A and 110A, in order to transfer the substrate 103. Component feeders 116A, 116B, 117A, and 117B are located on both sides of the work stations 110A and 110B.

In this type of moundng machine configuration, between the work stations 110A and 110B and the component feeders 116A and 117A, at positions corresponding to locations partway along the travel path of the head units 105A and 105B, there is an imaging unit 21. The configuration of the imaging unit 21 and that of the component recognition device, including the imaging unit 21, are the same as the implementation configuration described previously.

With this mounting machine, after the head units 105A and 105B have picked up the components at the component feeders, the head units move in the X axis direction, and as they pass the imaging unit 21 located partway along the travel path, component recognition is carried out. Following component recognition, the head units 105A and 105B continue moving until they reach the work stations 110A and 110B. In addition, the mounting position is adjusted by adjusting the positions of the head units 105A and 105B in the X axis direction and the positions of the work stations 110A and 110B in the Y axis directions, so that the components can be mounted on the substrate 103.

### [Effect of the Invention]

As described in the foregoing, this invention is designed to irradiate the component picked up by the nozzle member with light by means of an illumination device while imaging the attracted component by means of an imaging device, and recognizing the component based on the resulting image. In a mounting machine with this type of component recognition device, the brightness of the light with which the component is irradiated by the illumination device is detected, and the detected value is compared with a target value, with the volume of light emitted from the illumination device being controlled based on the deviation between the two values. As a result, feedback control is used to adjust the brightness of the light used to irradiate the attracted component with a high degree of precision, and to maintain the brightness of the component image at the appropriate level. Consequently, the accuracy of component recognition can be significantly improved.

With this invention, if the configuration is such that the elements of the imaging device and the illumination light detecting device have approximately equivalent sensitivity characteristics, detection can be carried out with the illumination light detecting device at the same sensitivity as the imaging device, even if the wavelength of the light from the illumination device changes, and the brightness of the component image can be adjusted to the appropriate level.

Furthermore, if the imaging device consists of a line sensor, and imaging is carried out while the head unit moves in a relative correspondence in relation to the line sensor, the travel speed of the head unit in relation to the line sensor is detected, and if the target value is adjusted based on this travel speed, the brightness of the component image can be adjusted appropriately even if the travel speed is outside the fixed range, when the head unit is accelerating or decelerating.

### [Explanation of the Symbols]

- 3:: Substrate
- 5:: Head unit
- 15:: X axis servo motor
- 16:: Position sensing device
- 20:: Nozzle member
- 21:: Imaging unit
- 22:: Camera
- 23:: Illumination unit
- 24a, 26a:: LEDs
- 30:: Photosensor
- 31:: Head detecting sensor
- 37:: Illumination control block

## Claims

1. A component recognition device comprising:
a movable head unit (5) having picking means (20) for picking at least one component;
imaging means (22) for imaging the component picked-up by said picking means (20);
illuminating means (23) for illuminating said component by irradiating light;
image recognition means (32) for recognizing the image of the component;
illumination light detecting means (30) for detecting the intensity of the light with which the component is irradiated, and
control means for controlling the illuminating means by setting a target value for the light intensity and comparing a value detected by the illumination light detecting means (30) with the target value,
**characterized by**
a means for adjusting the target value in response to the travel speed of the head unit (5).

2. Component recognition device according to claim 1, **characterized in that** a head detection sensor (31) for detecting the approach of said head unit (5) to said imaging means (22) is arranged near said imaging means (22) and that the component recognition device further comprises means of control for illuminating the illuminating means (23) as the head unit (5) approaches a fixed position near the imaging means (22) and turning off the illuminating means (23) after the head unit (5) has passed the imaging means (22).

3. Component recognition device according to claim 1 or 2, **characterized in that** said picking means is a nozzle member (20).

4. Component recognition device according to at least one of the claims 1 to 3, **characterized in that** said illuminating means (23) comprises a light emitting device comprising at least one LED.

5. Component recognition device according to at least one of the claims 1 to 4, **characterized in that** said imaging means (22) and said illumination light detecting means (30) employ elements having approximately equivalent sensivity.

6. Component recognition device according to at least one of the claims 1 to 5, **characterized in that** said illumination light detecting means (30) is positioned in the vicinity of said illuminating means (23) and outside of the path of the light directed from the illuminating means (23) to said component.

7. Component recognition device according to at least one of the claims 1 to 6, **characterized in that** said illumination light detecting means (30) is positioned in the head unit (5).

8. A mounting machine comprising a component recognition device according to at least one of the claims 1 to 7.

9. A method for recognizing at least one component comprising the steps of:
imaging the component while illuminating the component by irradiating light;
recognizing the component based on the resulting image;
detecting the brightness of the light with which the component is irradiated;
comparing the detected value with a target value, and
controlling the volume of light emitted on the basis of the difference between the two values,
**characterized in that**
the target value is adjusted in response to a travel speed of said component relative to a device for illuminating (23) and a device for imaging (32) the component.

10. Method according to claim 9, **characterized in that** the light is irradiated by at least one LED and that the volume of the light emitted is controlled by controlling the current supply to said LED.

11. Method according to claim 9 or 10, **characterized In that** the components are only illuminated during imaging of same.

12. Method according to at least one of the claims 9 to 11, **characterized In that** the target value is set in response to the type of component to be recognized.

## Patentansprüche

1. Bauteilerkennungsvorrichtung, die aufweist:
eine bewegbare Kopfeinheit (5), die eine Aufnehmeinrichtung (20) zum Aufnehmen von zumindest einem Bauteil hat;
eine Bildeinrichtung (22) zum Abbilden des durch die Aufnehmeinrichtung (20) aufgenommenen Bauteils ;
eine Beleuchtungseinrichtung (23) zum Beleuchten des Bauteiles durch Ausstrahlen von Licht;
eine Bilderkennungseinrichtung (32) zum Erkennen des Bildes des Bauteiles;
eine Beleuchtungslicht- Erfassungseinrichtung (30) zum Erfassen der Intensität des Lichtes, mit dem das Bauteil bestrahlt wird, und
eine Steuereinrichtung zum Steuern der Beleuchtungseinrichtung durch Festlegen eines Zielwertes für die Lichtintensität und Vergleichen eines durch das Beleuchtungslicht- Erfassungseinrichtung (30) erfassten Wertes, mit dem Zielwert,
**gekennzeichnet durch**
eine Einrichtung zum Einstellen des Zielwertes in Abhängigkeit von der Fahrgeschwindigkeit der Kopfeinheit (5).

2. Bauteilerkennungsvorrichtung nach Anspruch 1, **dadurch gekennzeichnet, dass** ein Kopferfassungssensor (31) zum Erfassen der Annährung der Kopfeinheit (5) an die Bildeinrichtung (22) in der Nähe der Bildeinrichtung (22) angeordnet ist und dass die Bauteilerkennungsvorrichtung außerdem eine Einrichtung zur Steuerung der Beleuchtung der Beleuchtungseinrichtung (23) aufweist, wenn sich die Kopfeinheit (5) einer feststehenden Position in der Nähe der Bildeinrichtung (22) annähert und Ausschalten der Beleuchtungseinrichtung (23), nachdem die Kopfeinheit (5) die Beleuchtungseinrichtung (23) passiert hat.

3. Bauteilerkennungsvorrichtung nach Anspruch 1 oder 2, **dadurch gekennzeichnet, dass** das Aufnehmeinrichtung ein Düsenteil (20) ist.

4. Bauteilerkennungsvorrichtung nach zumindest einem der Ansprüche 1 bis 3, **dadurch gekennzeichnet, dass** die Beleuchtungseinrichtung (23) eine lichtemittierende Vorrichtung aufweist, die zumindest eine LED aufweist.

5. Bauteilerkennungsvorrichtung nach zumindest einem der Ansprüche 1 bis 4, **dadurch gekennzeichnet, dass** die Bildeinrichtung (22) und die Beleuchtungslicht-Erfassungseinrichtung (30) Bauteile verwenden, die ungefähr die gleiche Empfindlichkeit haben.

6. Bauteilerkennungsvorrichtung nach zumindest einem der Ansprüche 1 bis 5, **dadurch gekennzeichnet, dass** die Beleuchtungslicht- Erfassungseinrichtung (30) in der Nähe der Beleuchtungsmittel (23) und außerhalb des Weges des Lichtes, gerichtet von der Beleuchtungseinrichtung (23) zu dem Bauteil, positioniert ist.

7. Bauteilerkennungsvorrichtung nach zumindest einem der Ansprüche 1 bis 6, **dadurch gekennzeichnet, dass** die Beleuchtungslicht- Erfassungseinrichtung (30) in der Kopfeinheit (5) positioniert ist.

8. Montagemaschine mit einer Bauteilerkennungsvorrichtung nach zumindest einem der Ansprüche 1 bis 7.

9. Verfahren zum Erkennen von zumindest einem Bauteil, das die Schritte aufweist von:
Abbilden des Bauteils , während das Bauteil durch Bestrahlungslicht beleuchtet wird;
Erfassen der Helligkeit des Lichtes , mit dem das Bauteil bestrahlt wird; Vergleichen des erfassten Wertes mit dem Zielwert, und
Steuern des Volumens des Lichtes, das auf der Grundlage des Unterschiedes zwischen den beiden Werten emittiert wird,
**dadurch gekennzeichnet, dass**
der Zielwert in Abhängigkeit von einer Fahrgeschwindigkeit des Bauteiles im Verhältnis zu einer Vorrichtung zum Beleuchten (23) und einer Vorrichtung zum Abbilden (32) des Bauteiles eingestellt wird.

10. Verfahren nach Anspruch 9, **dadurch gekennzeichnet, dass** das Licht durch zumindest eine LED ausgestrahlt wird und dass das Volumen des emittierten Lichtes durch Steuern der Stromzuführung zu der LED gesteuert wird.

11. Verfahren nach Anspruch 9 oder 10, **dadurch gekennzeichnet, dass** die Bauteile nur während des Abbildens derselben beleuchtet werden.

12. Verfahren nach zumindest einem der Ansprüche 9 bis 11, **dadurch gekennzeichnet, dass** der Zielwert in Abhängigkeit von der Art des Bauteils, die erkannt werden soll, festgelegt wird.

## Revendications

1. Dispositif de reconnaissance de composant comprenant :
une unité formant tête mobile (5) ayant des moyens de saisie (20) pour saisir au moins un composant ;
des moyens d'imagerie (22) pour prendre une image du composant saisi par lesdits moyens de saisie (20) ;
des moyens d'éclairage (23) pour éclairer ledit composant en irradiant de la lumière ;
des moyens de reconnaissance d'image (32) pour reconnaître l'image du composant ;
des moyens de détection de lumière d'éclairage (30) pour détecter l'intensité de la lumière avec laquelle le composant est irradié ; et
des moyens de commande pour commander les moyens d'éclairage en fixant une valeur cible pour l'intensité de lumière et en comparant une valeur détectée par les moyens de détection de lumière d'éclairage (30) à la valeur cible,
**caractérisé par**
des moyens pour ajuster la valeur cible en réponse à la vitesse de déplacement de l'unité formant tête (5).

2. Dispositif de reconnaissance de composant selon la revendication 1, **caractérisé en ce qu**'un capteur de détection de tête (31), pour détecter l'approche de ladite unité formant tête (5) vers lesdits moyens d'imagerie (22), est agencé près desdits moyens d'imagerie (22) et en ce que le dispositif de reconnaissance de composant comprend de plus des moyens de commande pour éclairer les moyens d'éclairage (23) lorsque l'unité formant tête (5) approche d'une position fixée près des moyens d'imagerie (22) et pour mettre les moyens d'éclairage (23) hors fonction après que l'unité formant tête (5) a dépassé les moyens d'imagerie (22).

3. Dispositif de reconnaissance de composant selon la revendication 1 ou 2, **caractérisé en ce que** lesdits moyens de saisie sont un élément formant buse (20).

4. Dispositif de reconnaissance de composant selon au moins une des revendications 1 à 3, **caractérisé en ce que** lesdits moyens d'éclairage (23) comprennent un dispositif émettant de la lumière comprenant au moins une DEL.

5. Dispositif de reconnaissance de composant selon au moins une des revendications 1 à 4, **caractérisé en ce que** lesdits moyens d'imagerie (22) et lesdits moyens de détection de lumière d'éclairage (30) utilisent des éléments ayant une sensibilité approximativement équivalente.

6. Dispositif de reconnaissance de composant selon au moins une des revendications 1 à 5, **caractérisé en ce que** lesdits moyens de détection de lumière d'éclairage (30) sont positionnés au voisinage desdits moyens d'éclairage (23) et à l'extérieur du chemin de la lumière dirigée des moyens d'éclairage (23) vers ledit composant.

7. Dispositif de reconnaissance de composant selon au moins une des revendications 1 à 6, **caractérisé en ce que** lesdits moyens de détection de lumière d'éclairage (30) sont positionnés dans l'unité formant tête (5).

8. Machine de montage comprenant un dispositif de reconnaissance de composant selon au moins une des revendications 1 à 7.

9. Procédé pour reconnaître au moins un composant comprenant les étapes consistant à :
prendre une image du composant tout en éclairant le composant en irradiant une lumière ;
reconnaître le composant sur la base de l'image résultante ;
détecter l'intensité de la lumière avec laquelle le composant est irradié ;
comparer la valeur détectée à une valeur cible ; et
commander le volume de lumière émise sur la base de la différence entre les deux valeurs,
**caractérisé en ce que**
la valeur cible est ajustée en réponse à une vitesse de déplacement dudit composant par rapport à un dispositif d'éclairage (23) et à un dispositif d'imagerie (32) du composant.

10. Procédé selon la revendication 9, **caractérisé en ce que** la lumière est irradiée par au moins une DEL et **en ce que** le volume de la lumière émise est maîtrisé en commandant l'alimentation en énergie vers ladite DEL.

11. Procédé selon la revendication 9 ou 10, **caractérisé en ce que** les composants sont seulement éclairés pendant la prise d'image de ces derniers.

12. Procédé selon au moins une des revendications 9 à 11, **caractérisé en ce que** la valeur cible est fixée en réponse au type de composant à reconnaître.
